(19) Europäisches Patentamt
European Patent Office
Office européen des brevets

(11) Veröffentlichungsnummer: **0 146 985**
**B1**

(12) **EUROPÄISCHE PATENTSCHRIFT**

(45) Veröffentlichungstag der Patentschrift: **06.02.91**

(51) Int. Cl.⁵: **C 30 B 23/02**, C 30 B 29/28, C 30 B 33/00

(21) Anmeldenummer: **84201733.7**

(22) Anmeldetag: **28.11.84**

(54) **Verfahren zur Herstellung dünner einkristalliner ferrimagnetischer Granatschichten durch Kathodenzerstäubung.**

(30) Priorität: **03.12.83 DE 3343768**

(43) Veröffentlichungstag der Anmeldung:
**03.07.85 Patentblatt 85/27**

(45) Bekanntmachung des Hinweises auf die Patenterteilung:
**06.02.91 Patentblatt 91/06**

(84) Benannte Vertragsstaaten:
**DE FR GB IT**

(56) Entgegenhaltungen:
**US-A-3 887 451**
**US-A-3 989 352**

**IEEE TRANSACTIONS ON MAGNETICS, Band MAG-20, Nr. 5, September 1984, Seiten 983-985, IEEE, New York, US; J.-P. KRUMME et al.: "Bismuth-substituted iron garnet films prepared by RF diode sputtering"**

(73) Patentinhaber: **Philips Patentverwaltung GmbH
Wendenstrasse 35 Postfach 10 51 49
D-2000 Hamburg 1 (DE)**
(84) **DE**

(73) Patentinhaber: **N.V. Philips' Gloeilampenfabrieken
Groenewoudseweg 1
NL-5621 BA Eindhoven (NL)**
(84) **FR GB IT**

(72) Erfinder: **Doormann, Volker
Borchertring 27
D-2000 Hamburg 60 (DE)**
Erfinder: **Eckart, Rainer
Lausitzer Weg 26
D-2000 Hamburg 61 (DE)**
Erfinder: **Krumme, Jens-Peter
Heydornweg 4
D-2000 Hamburg 55 (DE)**

(74) Vertreter: **Nehmzow-David, Fritzi-Maria et al
Philips Patentverwaltung GmbH Wendenstrasse 35 Postfach 10 51 49
D-2000 Hamburg 1 (DE)**

**EP 0 146 985 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

**Beschreibung**

Verfahren zur Herstellung dünner einkristalliner ferromagnetischer Granatschichten.

Die Erfindung betrifft ein Verfahren zur Herstellung dünner einkristalliner ferrimagnetischer Granatschichten einer Zusammensetzung gemäß der Formel $Gd_{3-x}Bi_xFe_{5-y}Al_yO_{12}$ mit $0 < x \leq 1{,}8$ und $0 < y \leq 1{,}2$ auf einem Substrat.

Wismut-haltige Eisen-Granatzusammensetzungen der allgemeinen Formel $R_{3-x}Bi_xFe_{5-y}A_yO_{12}$ mit R = Y, Nd, Sm, Eu, Gd mit $0{,}2 < x < 2{,}0$ und A = Ga oder Al mit $0 < y < 1{,}5$ oder A = In oder Sc mit $0 < y < 0{,}8$ sind aus US-PS 3 989 352 zur Herstellung von magnetooptischen Bauelementen bekannt. Ein Verfahren, wie diese Granate hergestellt werden sollen, ist jedoch nicht offenbart.

Die Herstellung von dünnen ferrimagnetischen Granatschichten hat in den letzten Jahren zunehmend an Bedeutung gewonnen wegen ihrer Anwendungsmöglichkeiten auf magnetischem bzw. magnetooptischem Gebiet, z.B. als Displays, für optische Drucker, für Blasendomänenanordnungen, in Gyrolasern und für Bauelemente im Bereich der optischen Kommuniktion, z.B. aktive Elemente in Speichervorrichtungen, die mittels elektromagnetischer Strahlung adressierbar sind.

Aus US-PS 3 887 451 sind durch Kathodenzerstäubung hergestellte epitaxiale Granatschichten der allgemeinen Zusammensetzung $A_xB_{3-x}C_yD_{5-y}O_{12}$ mit $0 < x < 3$ und $0 < y < 3$ und mit A = Lanthanoid unter Einschluß von Gd, Eu, Tb und Er, mit B = Y, La oder Sc, mit C = Al oder Ga und mit D = Fe, Ni oder Co bekannt.

Zu den besonderen Problemen, die sich bei der Abscheidung von stöchiometrischen Granatschichten ergeben, die Wismut enthalten sollen, kann der Fachmann dieser Vorveröffentlichung nichts entnehmen, da Wismut als Substituent nicht vorgesehen ist.

Bei der Herstellung von Granatschichten hat die Abscheidung mittels Kathodenzerstäubung (HF-Plasmazerstäubung oder RF-Diodensputtering) für die industrielle Fertigung an Interesse gewonnen, weil auf diese Weise die Schwierigkeit, homogene Abscheidungen dielektrischer Schichten auch über größere Flächen zu erreichen, noch am ehesten überwunden werden kann.

Das traditionelle Vorgehen, einkristalline Granatschichten mittels Flüssigphasenepitaxie (LPE) auf einkristallinen Substraten mit etwa angepasster Gitterkonstante abzuscheiden, ist teuer und bislang noch nicht so weit entwickelt, daß eine Großserienfertigung mit reproduzierbarem Erfolg arbeiten kann. Schwierigkeiten ergeben sich z.B. bei den einkristallinen Substraten, die — abhängig von den Abmessungen der Einkristalle, aus denen sie geschnitten werden — nicht in beliebiger Größe hergestellt werden können.

Dem Flüssigphasenepitaxieprozeß gegenüber bietet die HF-Plasmazerstäubung für die Herstellung von Granatschichten eine Reihe von Vorteilen; es werden keine Edelmetalle für die einzusetzenden Vorrichtungen benötigt, es kann der große technologische Aufwand mit der Herstellung einkristalliner Substrate entfallen und es ist auch eine kontinuierliche Prozeßführung möglich. Darüberhinaus bietet der HF-Plasmazerstäubungsprozeß den Vorteil einer größeren Vielseitigkeit, da eine große Vielfalt von Substrat/Schichtkombinationen möglich ist und Schichten größerer Abmessungen hergestellt werden können. Es ist jedoch bislang noch nicht möglich gewesen, Granatschichten, die aus dem Flüssigphasenepitaxieprozeß als vorteilhaft bekannt waren, mittels eines HF-Plasmazerstäubungsprozesses so herzustellen, daß reproduzierbar stöchiometrische Schichten erhalten werden, die darüberhinaus auch mit so hohen Zerstäubungsraten erreicht werden, daß auch dicke ferrimagnetische Granatschichten, wie sie z.B. für Modulatoranwendungen erforderlich sind, innerhalb einer auch für einen industriellen Fertigungsprozeß brauchbaren kurzen Zeitdauer abgeschieden werden können. Dies betrifft z.B. mit Wismut substituierte Eisengranatschichten.

Der Erfindung liegt die Aufgabe zugrunde, ein Verfahren anzugeben, mit dem auch mit Wismut dotierte Eisengranatschichten auf effiziente Weise unter Vermeidung der oben genannten Nachteile hergestellt werden können.

Diese Aufgabe wird erfindungsgemäß dadurch gelöst, daß die Schichten durch Kathodenzerstäubung mit anschließender Kristallisation der abgeschiedenen Schicht durch einen Temperprozeß hergestellt werden, derart, daß ein Target eingesetzt wird, das die am Schichtaufbau beteiligten Elemente in Form ihrer Oxide in einer der gewünschten Schichtzusammensetzung entsprechenden Konzentration mit Wismutoxid im Überschuß enthält, daß an die Targetelektrode sowie an die Substratelektrode konstante, geregelte HF-Spannungen angelegt werden, derart, daß $\geq$90% der dem HF-Generator entnommenen, für den Zerstäubungsprozeß erforderlichen HF-Leistung über die Targetelektrode und $\leq$10% der für den Zerstäubungsprozeß erforderlichen HF-Leistung über die Substratelektrode dem Plasma zugeführt werden und daß die Substratelektrode auf eine Temperatur von 300°C konstant eingestellt wird.

Ein besonderes Problem bei der Abscheidung von Wismut-substituierten Eisengranatschichten mittels Kathodenzerstäubung ist die im Vergleich zu den anderen Bestandteilen der Schicht wesentlich höhere Zerstäubungsausbeute des Wismuts in oxidischer Bindung. Bei der Durchführung des klassischen HF-Plasmazerstäubens mit den üblicherweise eingesetzten Parametern findet deshalb durch Rückzerstäubungsprozesse und thermische Prozesse, z.B. Erwärmen des Substrates infolge energetischer Sekundärelektronen, an der Substratelektrode eine Verarmung an Wismut in den erzeugten Schichten statt. Überraschenderweise wurde nun gefunden, daß Schichten gewünschter, stöchiometrischer Zusammensetzung reproduzierbar aufgestäubt werden können, wenn erstens ein Überschuß an Wismutoxid im Target vorgegeben ist und zweitens an die Substratelektrode eine — wie oben beschrieben — HF-Spannung (sog. Substrat-Bias) angelegt wird.

Da außerdem die Temperatur an der Substratelektrode die Wismutkonzentration in der aufzustäubenden Schicht beeinflußt, ist es notwendig, die Temperatur an der Substratelektrode auf einen Wert von 300°C konstant einzustellen.

Wegen der, wie gefunden wurde, sehr großen Abhängigkeit des Wismutgehaltes der erzeugten Schicht von der HF-Spannung an der Substratelektrode ist es erforderlich, die HF-Spannungen an den Elektroden konstant zu regeln, z.B. über Rechner.

Nach vorteilhaften Weiterbildungen der Erfindung wird eine Schicht der Zusammensetzung $Gd_2Bi_1Fe_{4,3}Al_{0,9}O_{12}$ hergestellt.

Die nach dem erfindungsgemäßen Verfahren hergestellten $(Gd,Bi)_3$ $(Fe,Al)_5O_{12}$-Schichten haben den Vorteil, daß ihre optischen und magnetooptischen Eigenschaften wie auch die Temperaturabhängigkeit der Sättigungsmagnetisierung mit den Werten von mittels Flüssigphasenepitaxie hergestellten Schichten entsprechender Zusammensetzung nahezu übereinstimmen, daß aber außerdem, anders als bei mittels Flüssigphasenepitaxie hergestellten Schichten, die vorliegenden Schichten über ihre gesamte Schichtdicke eine hohe Homogenität aufweisen. Dadurch, daß die für den Wismutgehalt in der Schicht entscheidende Vorspannung am Substrat sehr genau über Rechner geregelt werden kann, ergibt sich eine gute Einstellbarkeit der gewünschten Schichtzusammensetzung und eine gute Reproduzierbarkeit der Schichteigenschaften. Ein weiterer Vorteil ist, daß die Abscheidungsrate relativ hoch liegt, was ein entscheidender Vorteil für eine industrielle Fertigung ist. Als Ausführungsbeispiel der Erfindung wird die Herstellung einer Granatschicht der Zusammensetzung $Gd_2Bi_1Fe_{4,3}Al_{0,9}O_{12}$ beschrieben.

Für die Kathodenzerstäubung können im Handel erhältliche, mit HF-Spannung zu betreibende Kathodenzerstäubungsanlagen in Diodenanordnung benutzt werden, wobei als notwendige Hilfsvorrichtung eine Meßvorrichtung zur Messung der effektiven Hochfrequenzspannung sowohl an der Targetelektrode als auch an der Substratelektrode vorzusehen ist. Die für den Zerstäubungsprozeß erforderliche HF-Leistung wird derart eingespeist, daß $\leqslant$90% der HF-Leistung über die Targetelektrode und $\leqq$10% der HF-Leistung über die Substratelektrode dem Plasma zugeführt werden. Der Rezipient liegt an Masse. Die an den Elektroden anliegenden HF-Spannungen werden dabei an den Elektrodenrückseiten gemessen, wobei diese HF-Spannungen konstant geregelt werden über Rechner. Die Zusammensetzung der herzustellenden Schichten ist entscheidend von der an die Substratelektrode angelegten HF-Spannung abhängig, da die Zerstäubungsausbeuten der Schichtbestandteile unterschiedlich sind. Über die Substratspannung ist insbesondere der Wismutgehalt der herzustellenden Schichten steuerbar, während die Konzentration der Oxide der übrigen am Schichtaufbau beteiligten Elemente im wesentlichen über die Targetzusammensetzung vorzugeben ist. Als Energiequelle für die Zerstäubungseinrichtung diente ein normaler HF-Generator mit einer Ausgangsleistung von $\leqq$2kW. Die Betriebsfrequenz lag hierbei bei 13,56 MHz. Als Target (kathodische Zerstäubungsquelle) diente ein durch Heißpressen aus den Oxiden der am Schichtaufbau beteiligten Elemente hergestellter Körper eines Durchmessers von 7,6 cm, einer Dicke von 5 mm und einer Porosität von 0,2% mit folgender Zusammensetzung (Angaben in Gew.%):

$Gd_2O_3$ 19,9
$Bi_2O_3$ 55,1
$Fe_2O_3$ 22,5
$Al_2O_3$ 2,5.

Der Targetkörper wurde auf eine Trägerplatte mit einem gut wärmeleitfähigen Kleber aufgeklebt und dieser Verbundkörper wird dann auf der Targetelektrode befestigt.

Der Targetkörper kann auch durch Kaltpressen der Oxide der am Schichtaufbau beteiligten Elemente und anschließendes Sintern hergestellt werden. Es wurden kaltgepresste Targetkörper gleicher Zusammensetzung, wie für den durch Heißpressen hergestellten Targetkörper angegeben, hergestellt, wobei als Träger eine Platte mit profilierter Oberfläche (Graben- und Kanalstruktur) verwendet wurde, um eine gute Haftung des Targetmaterials am Träger zu erreichen. Es wurden kaltgepresste Targets eines Durchmessers von 15,24 cm und einer Dicke von 1 mm eingesetzt.

Um Verlustwärme zu verhindern, ist es zweckmäßig, z.B. durch Wasser gekühlte Targetelektroden zu verwenden.

Als Substratelektrode wurde eine, auf eine Temperatur von 300°C aufgeheizte hochfrequenztaugliche Elektrode eines Durchmessers von 15,24 cm eingesetzt. Als Substrate wurden Ca/Mg/Zr-substituierte Gadolinium-Gallium-Granat-Einkristallscheiben mit (111)- Orientierung oder Platten aus Gläsern mit hoher Transformationstemperatur und einem, dem aufzubringenden Schichtmaterial angepassten thermischen Ausdehnungskoeffizienten verwendet. Die Auswahl des Substrates hängt ab vom Anwendungszweck der hergestellten Schicht. Werden großflächige Schichten, z.B. für Displays, benötigt, sind insbesondere Glassubstrate geeignet.

Die Zerstäubungsapparatur wurde zunächst mit einer Vakuumpumpe bis zu einem Druck von etwa $10^{-5}$mbar evakuiert, anschließend wurde reiner Sauerstoff bis zu einem Druck von etwa 2 x $10^{-2}$ mbar eingeleitet. Der Elektrodenabstand betrug 35 mm. Die Niederschlagsrate lag bei etwa 0,3 µm/h bei Anwendung des kaltgepressten Targetkörpers und bei 0,2 µm/h bei Anwendung des heißgepressten Targetkörpers. Die an der HF-Zuleitung an der Rückseite der Elektroden gemessenen Hochfrequenzspannungen betrugen $500V_{eff}$ für die Targetelektrode und $20V_{eff}$ für die Substratelektrode, wobei die HF-Spannungen an den Elektroden von einem Rechner auf 1% Genauigkeit konstant geregelt wurden. Die typische Schwankung in der Reproduzierbarkeit der Schichtzusammensetzung liegt bei diesen Bedingungen bei etwa 1%.

Vor der Abscheidung der Schichten wurden Target und Substrat jeweils 10 min durch Zerstäubung geätzt und das Substrat wurde etwa 30 min bei Abscheidungstemperatur ausgeheizt, wobei die Substrate vor dieser Behandlung in Phosphorsäure von 150°C 20s geätzt, in deionisiertem, fließendem Wasser gespült und zentrifugiert werden.

Nach Abscheidung in der Kathodenzerstäubungsanlage sind die Schichten röntgenamorph. Eine Umwandlung in einphasige einkristalline Wismut-Eisengranat-Schichten erfolgte durch Erhitzen in Sauerstoffatmosphäre bei einer Temperatur von etwa 730°C für den Fall, daß einkristalline Granatsubstrate verwendet wurden und bei einer Temperatur von etwa 780°C für den Fall, daß Glassubstrate verwendet wurden. Der Temperprozeß zur Umwandlung in die kristalline Phase wurde mit folgendem Temperaturprofil durchgeführt: Aufheizrate 30°C/h bei Glassubstraten, 100°C/h bei einkristallinen Granatsubstraten; Halten der Maximaltemperatur über eine Dauer von 1 bis 2 h; Abkühlrate 30°C/h bei Glassubstraten und 100°C/h bei einkristallinen Granatsubstraten.

Durch magneto-optische Spektrographie und durch Röntgenstrukturanalysen wurde festgestellt, daß in den Schichten $(Gd,Bi)_3(Fe,Al)_5O_{12}$ als einzige phase vorlag.

Messungen an den auf die beschriebene Weise erhaltenen einkristallinen Schichten zeigten folgende Eigenschaften:

Magnetischer Kompensationspunkt der Sättigungsmagnetisierung bei 300 K

Uniaxiale magnetische Anisotropie bei etwa $1 \times 10^4$ erg/cm$^3$

Brechungsindex bei 633 nm Wellenlänge: 2,34

Spezifische Faradaydrehung bei 633 nm Wellenlänge: 1,1°/µm Schichtdicke

Optischer Absorptionskoeffizient bei 633 nm Wellenlänge: 1000/cm

Dicke der abgeschiedenen Schichten: 1—2 µm.

Die besonderen Vorteile des vorliegenden Verfahrens liegen darin, daß trotz der im Vergleich zu den anderen Bestandteilen der Schicht wesentlich höheren Zerstäubungsausbeute des Wismutoxids in der abgeschiedenen Schicht eine vorgegebene Schichtzusammensetzung reproduzierbar erreicht werden kann, wobei die abgeschiedenen Schichten eine hohe Homogenität über die gesamte Schichtdicke aufweisen. Die mit dem vorliegenden Verfahren erreichbare hohe Abscheidungsrate ist im Hinblick auf eine effiziente Fertigung sehr vorteilhaft.

**Patentansprüche**

1. Verfahren zur Herstellung dünner einkristalliner ferrimagnetischer Granatschichten einer Zusammensetzung gemäß der Formel $Gd_{3-x}Bi_x Fe_{5-y}Al_yO_{12}$ mit $0 < x \leq 1,8$ und $0 < y \leq 1,2$ auf einem Substrat,

dadurch gekennzeichnet,

daß die Schichten durch Kathodenzerstäubung mit anschließender Kristallisation der abgeschiedenen Schicht durch einen Temperprozeß hergestellt werden, derart, daß ein Target eingesetzt wird, das die am Schichtaufbau beteiligten Elemente in Form ihrer Oxide in einer der gewünschten Schichtzusammensetzung entsprechenden Konzentration mit Wismutoxid im Überschuß enthält, daß an die Targetelektrode sowie an die Substratelektrode konstante, geregelte HF-Spannungen angelegt werden, derart, daß $\geq$90% der dem HF-Generator entnommenen, für den Zerstäubungsprozeß erforderlichen HF-Leistung über die Targetelektrode und $\leq$10% der für den Zerstäubungsprozeß erforderlichen HF-Leistung über die Substratelektrode dem Plasma zugeführt werden und daß die Substratelektrode auf eine Temperatur von 300°C konstant eingestellt wird.

2. Verfahren nach Anspruch 1, dadurch gekennzeichnet, daß die Zusammensetzung der Schicht der Formel $Gd_2Bi_1Fe_{4,3}Al_{0,9}O_{12}$ entspricht.

3. Verfahren nach Anspruch 1, dadurch gekennzeichnet, daß das Target durch Heißpressen aus den Oxiden der am Schichtaufbau beteiligten Elemente hergestellt wird.

4. Verfahren nach Anspruch 1, dadurch gekennzeichnet, daß das Target durch Kaltpressen aus den Oxiden und Sintern der am Schichtaufbau beteiligten Elemente hergestellt wird.

5. Verfahren nach den Ansprüchen 2 bis 4, dadurch gekennzeichnet, daß das Target die nachfolgend angegebene Zusammensetzung hat (Angaben in Gew.%):

$Gd_2O_{12}$ 19.9
$Bi_2O_3$ 55.1
$Fe_2O_3$ 22.5
$Al_2O_3$ 2.5

6. Verfahren nach Anspruch 1, dadurch gekennzeichnet, daß als Substrat eine in (111)-Orientierung geschnittene nichtmagnetische Granat-Einkristallscheibe eingesetzt wird.

7. Verfahren nach Anspruch 6, dadurch gekennzeichnet daß als Substrat Calcium/Magnesium/Zirkon-substituierter Gadolinium-Gallium-Granat ($(Gd,Ca)_3(Ga,Mg,Zr)_5O_{12}$) eingesetzt wird.

8. Verfahren nach Anspruch 1, dadurch gekennzeichnet, daß ein amorphes Substrat eingesetzt wird.

9. Verfahren nach Anspruch 8, dadurch gekennzeichnet, daß als Substrat ein Glas mit hoher Glastransformationstemperatur und mit einem der abzuscheidenden Schicht angepassten thermischen Ausdehnungskoeffizienten eingesetzt wird.

10. Verfahren nach Anspruch 1, dadurch gekennzeichnet, daß die Schicht in reiner Sauerstoffatmosphäre abgeschieden und getempert wird.

11. Verfahren nach Anspruch 6, dadurch gekennzeichnet, daß bei einer Temperatur von etwa 730°C getempert wird.

12. Verfahren nach Anspruch 9, dadurch

gekennzeichnet, daß bei einer Temperatur von etwa 780°C getempert wird.

13. Verwendung von ferrimagnetischen Granatschichten, hergestellt nach den Ansprüchen 1 bis 12, in Displays.

14. Verwendung von ferrimagnetischen Granatschichten, hergestellt nach den Ansprüchen 1 bis 12, in optischen Druckern.

**Revendications**

1. Procédé pour la fabrication de couches minces de grenat ferrimagnétiques monocristallines d'une composition répondant à la formule $Gd_{3-x}Bi_xFe_{5-y}Al_yO_{12}$, $0 < x \leq 1{,}8$ et $0 < _y \leq 1{,}2$ sur un substrat, caractérisé en ce que les couches sont réalisées par pulvérisation cathodique suivie d'une cristallisation de la couche déposée par un processus de recuit à l'aide d'une cible qui contient en excès les éléments participant à la composition de couche sous forme de leurs oxydes dans une concentration correspondant à la composition de couche requise avec de l'oxyde de bismuth, que des tensions HF réglées constantes sont appliquées à l'électrode de cible ainsi qu'à l'électrode de substrat de façon que 90% ou plus de la puissance HF prélevée sur le générateur HF et nécessaire pour le processus de pulvérisation soit amenée par l'intermédiaire de l'électrode de cible et 10% ou moins de la puissance HF nécessaire pour le processus de pulvérisation soit amenée par l'intermédiaire de l'électrode de substrat au plasma et que l'électrode de substrat est établie de façon continue à une température de 300°C.

2. Procédé selon la revendication 1, caractérisé en ce que la composition de la couche répond à la formule $Gd_2Bi_1Fe_{4,3}Al_{0,7}O_{12}$.

3. Procédé selon la revendication 1, caractérisé en ce que la cible est réalisée par pressage à chaud à partir des oxydes des éléments participant à la formation de la couche.

4. Procédé selon la revendication 1, caractérisé en ce que la cible est réalisée par pressage à froid à partir des oxydes et frittage des éléments participant à la formation de la couche.

5. Procédé selon les revendications 2 à 4, caractérisé en ce que la cible présente la composition indiquée ci-après (données en % en poids):

$Gd_2O_3$ 19,9
$Bi_2O_3$ 55,1
$Fe_2O_3$ 22,5
$Al_2O_3$ 2,5.

6. Procédé selon la revendication 1, caractérisé en ce qu'un disque monocristallin de grenat non magnétique coupé selon l'orientation (111) est utilisé comme substrat.

7. Procédé selon la revendication 6, caractérisé en ce que du grenat à base de gallium-gadolinium portant comme substituant du calcium/magnésium/zirconium ($(Gd,Ca)_3(Ga,Mg,Zr)_5O_{12}$ est utilisé comme substrat.

8. Procédé selon la revendication 1, caractérisé par l'utilisation d'un substrat amorphe.

9. Procédé selon la revendication 8, caractérisé en ce qu'un verre présentant une température de transformation de verre élevée et un coefficient de dilatation thermique adapté à celui de la couche à déposer est utilisé comme substrat.

10. Procédé selon la revendication 1, caractérisé en ce que la couche est déposée dans une atmosphère d'oxygène pur et ensuite recuite.

11. Procédé selon la revendication 6, caractérisé en ce que le procédé s'effectue à une température d'environ 730°C.

12. Procédé selon la revendication 9, caractérisé en ce que le recuit s'effectue à une température d'environ 780°C.

13. Application de couches de grenat ferrimagnétiques, fabriquées selon les revendications 1 à 12 dans des dispositifs d'affichage.

14. Application de couches de grenat ferrimagnétiques, fabriquées selon les revendications 1 à 12 dans des imprimantes optiques.

**Claims**

1. A method of manufacturing thin monocrystalline ferrimagnetic garnet layers on a substrate, said garnet layers having a composition in accordance with the formula $Gd_{3-x}Bi_xFe_{5-y}Al_yO_{12}$, where $0 < x \leq 1.8$ and $0 < y \leq 1.2$, characterized in that the layers are manufactured by cathode sputtering followed by crystallisation of the deposited layer by a tempering process, in such a manner that a target is used which comprises the elements used in the construction of the layer in the form of their oxides in a concentration corresponding to the desired layer composition, with an excess of bismuth oxide, and that constant, controlled HF voltages are applied to the target electrode as well as to the substrate electrode in such a manner that $\geqq$90% of the HF power required for the sputtering process and drawn from the HF generator is applied to the plasma via the target electrode and $\leqq$10% of the HF power required for the sputtering process is applied to the plasma via the substrate electrode, and that the substrate electrode is constantly adjusted at a temperature of 300°C.

2. A method as claimed in Claim 1, characterized in that the composition of the layer corresponds to the formula $Gd_2Bi_1Fe_{4.3}Al_{0.7}O_{12}$.

3. A method as claimed in Claim 1, characterized in that the target is manufactured by hot-pressing the oxides of the elements used in the construction of the layer.

4. A method as claimed in Claim 1, characterized in that the target is manufactured by cold-pressing the oxides and sintering the elements used in the construction of the layer.

5. A method as claimed in Claims 2 to 4, characterized in that the target has the following composition (in % by weight):

$Gd_2O_3$ 19.9
$Bi_2O_3$ 55.1
$Fe_2O_3$ 22.5
$Al_2O_3$ 2.5.

6. A method as claimed in Claim 1, characterized in that a (111) oriented non-magnetic garnet single crystal disc is used as the substrate.

7. A method as claimed in Claim 6, characterized in that calcium/magnesium/zirconium-substituted gadolinium-gallium-garnet ($(Gd,Ca)_2$-$(Ga,Mg,Zr)_5O_{12}$) is used as the substrate.

8. A method as claimed in Claim 1, characterized in that an amorphous substrate is used.

9. A method as claimed in Claim 8, characterized in that a type of glass having a high glass transformation temperature and a coefficient of thermal expansion adapted to the layer to be deposited is used as the substrate.

10. A method as claimed in Claim 1, characterized in that the layer is deposited and tempered in a pure oxygen atmosphere.

11. A method as claimed in Claim 6, characterized in that tempering is carried out at a temperature of approximately 730°C.

12. A method as claimed in Claim 9, characterized in that tempering is carried out at a temperature of approximately 780°C.

13. The use of ferrimagnetic garnet layers, manufactured in accordance with any of the Claims 1 to 12, in displays.

14. The use of ferrimagnetic garnet layers, manufactured in accordance with Claims 1 to 12, in optical printers.